# FASCICULE DE BREVET EUROPEEN

(11) **EP 0 589 786 B1**
(45) Date de publication et mention de la délivrance du brevet: **10.12.1997**
(21) Numéro de dépôt: 93402316.9
(22) Date de dépôt: 22.09.1993
(51) Int. Cl.: H01R 23/68, H05K 7/14, G06F 13/40

(54) **Dispositif de connexion pour installation de transmission de signaux**
Verbindervorrichtung für Signalübertragungseinrichtung
Connection device for signal transmission equipment

(30) Priorité: 23.09.1992 FR 9211311
(43) Date de publication de la demande: 30.03.1994
(73) Titulaire: PROFESSIONAL GENERAL ELECTRONIC PRODUCTS P.G.E.P., 92400 Courbevoie (FR)
(72) Inventeur: Blanchot, Michèle, F-78270 Cravent (FR); Potier, Daniel, F-27950 Saint Just (FR)
(74) Mandataire: Loyer, Bertrand

(56) Documents cités:
- EP-A- 0 158 122
- EP-A- 0 164 949
- WO-A-88/04484
- DE-U- 8 717 242
- DE-U- 8 717 244
- FR-A- 2 513 477
- FR-A- 2 552 881
- US-A- 3 475 657
- US-A- 4 685 031
- US-A- 5 037 310

## Description

La présente invention concerne d'une manière générale un boîtier de raccordement pour le branchement d'un circuit d'utilisation à courant faible. L'on appelle circuit à courant faible les circuits de transmission de signaux, l'on peut citer à titre d'exemple les circuits téléphoniques ou les circuits de raccordement d'ordinateurs.

De manière habituelle, de tels connecteurs sont portés par un boîtier auquel les informations sont amenées par un câble multibrin. Le boîtier est fixé sur une cloison en un point déterminé en fonction de l'emplacement de l'appareil utilisateur, et la longueur du câble est adaptée à la position dudit boîtier.

Une telle installation rend pratiquement impossible toute modification de la position du connecteur lorsque l'on modifie l'aménagement du poste de travail dans lequel sont utilisés les signaux puisque la longueur du câble ne peut être modifiée ; les installateurs ont généralement soin de laisser des boucles de fil dans l'installation mais celles-ci ne peuvent être que de longueur limitée et ne peuvent permettre de grandes modifications des installations.

Un autre inconvénient de ces installations tient au fait que chaque boîtier porte un connecteur spécifique et qu'il n'est pas possible, lorsque le boîtier est installé, de modifier sa face avant afin de changer le connecteur spécifique. En cas de modification des caractéristiques techniques du réseau d'informations installé, il est nécessaire de refaire toute l'installation si les connecteurs spécifiques nécessaires sont différents des premiers.

Il a été proposé dans le FR 2 513 477 des moyens permettant la mise en place dans un châssis d'unités fonctionnelles d'importance variable en fournissant à ces unités fonctionnelles des moyens de communication interne propres à chacune.

L'équipement proposé par ce document antérieur comporte d'une part un bus continu et d'autre part un bus discontinu composé de segments de conducteurs, isolés les uns des autres.

Le bus continu porte des dispositifs de contact unipolaires dans lesquels l'on peut introduire des cartes de circuit imprimé, lesdites cartes de circuit imprimé étant ainsi alimentées en courant et avec des informations circulant sur les conducteurs du bus continu, chacune des cartes ainsi constituant un élément d'une des unités fonctionnelles.

Au delà du besoin de transmettre des signaux vers l'extérieur, vers une autre unité fonctionnelle par exemple, chaque unité fonctionnelle a besoin de transmettre des signaux entre les éléments qui la compose.

Le bus discontinu est alors utilisé pour créer pour chaque unité fonctionnelle un bus local de longueur juste nécessaire à ses besoins. Chaque unité fonctionnelle comporte une carte principale par laquelle les données circulant sur le bus continu sont prélevées pour être utilisées dans ledit bus local.

Cet équipement peut alors être utilisé pour fournir des données communes à plusieurs unités fonctionnelles disposées les unes à la suite des autres mais ne peut être utilisé pour acheminer plusieurs types d'informations qui seront utilisées à la demande en fonction de l'appareil branché.

L'invention tend à proposer un dispositif de distribution de signaux courants faibles, évolutif, grâce auquel l'on peut à la demande modifier la position ou les caractéristiques techniques du connecteur spécifique sans devoir refaire le câblage de l'installation.

A cet effet, l'invention propose un dispositif de connexion pour installation de transmission de signaux caractérisé en ce que :
- il comporte un circuit imprimé portant au moins un bus placé sur un support isolant et alimenté par un câble d'alimentation et des conducteurs de masse, de telle sorte que ledit circuit imprimé soit à impédance caractéristique d'une valeur constante sur toute la longueur du bus correspondant à celle des câbles d'alimentation,
- ledit bus est disposé en segments séparés avec des moyens de jonction assurant la transmission des signaux de l'un à l'autre desdits segments,
- des moyens de connexion ou plots comportant une cartelette de circuit imprimé destinée à l'utilisation des informations transportées par au moins un bus sont positionnés dans des moyens de jonction, ladite cartelette présentant des moyens disposés en regard du bus transportant les signaux à utiliser assurant la transmission des informations vers l'utilisation et des moyens assurant la jonction des segments des bus non utilisés.

Le dispositif selon l'invention est encore remarquable en ce que :
- les moyens de jonction comportent des contacts fermés en position de repos afin d'assurer la continuité de chacun des bus et conducteurs de masse,
- les moyens de jonction comportent des contacts ouverts au repos dans lesquels sont insérés des pions de liaison des contacts afin d'assurer la continuité de chacun des bus et conducteurs de masse,
- les moyens de jonction sont des pions portant des contacts assurant la jonction des segments de bus et des conducteurs de masse,
- un bornier assure la jonction du ou des câbles de transmission de signaux au ou aux bus,
- le bornier est un bornier conforme à ceux usuellement utilisés pour assurer la connexion entre des câbles et des pistes de circuit imprimé,
- la cartelette de circuit imprimé des plots présente des pistes entrant en contact, directement ou indirectement, avec les segments de bus et de conducteurs de masse,
- un plot assure la jonction des câbles et des bus par l'intermédiaire d'un moyen de jonction,
- les plots présentent une face supérieure portant un connecteur spécifique auquel sont amenés les signaux véhiculés par l'un des bus,
- la cartelette porte un circuit imprimé assurant une fonction,
- le support isolant est inséré dans un rail,
- les cartelettes sont programmables par tout moyen électrique ou mécanique.

La présente invention sera mieux comprise par la description qui va suivre en référence au dessin joint sur lequel :
- la figure 1 est un schéma de principe en plan du dispositif de connexion selon l'invention,
- la figure 2 représente schématiquement, en élévation latérale, le mode d'emploi du dispositif de connexion selon l'invention,
- les figures 3a et 3b représentent respectivement le recto et le verso du circuit imprimé,
- la figure 4 est une vue en perspective d'un premier mode de réalisation de l'invention,
- la figure 5 est une vue partielle en coupe d'un second mode de réalisation de l'invention,
- les figures 6a et 6b représentent le positionnement d'une cartelette entre les contacts d'un dispositif de jonction,
- la figure 7 est une figure analogue à la figure 5 pour un troisième mode de réalisation de l'invention,
- la figure 8 montre un exemple de configuration du dispositif après insertion des plots,
- les figures 9a à 9d représentent différents modes d'utilisation des signaux propagés par les bus.

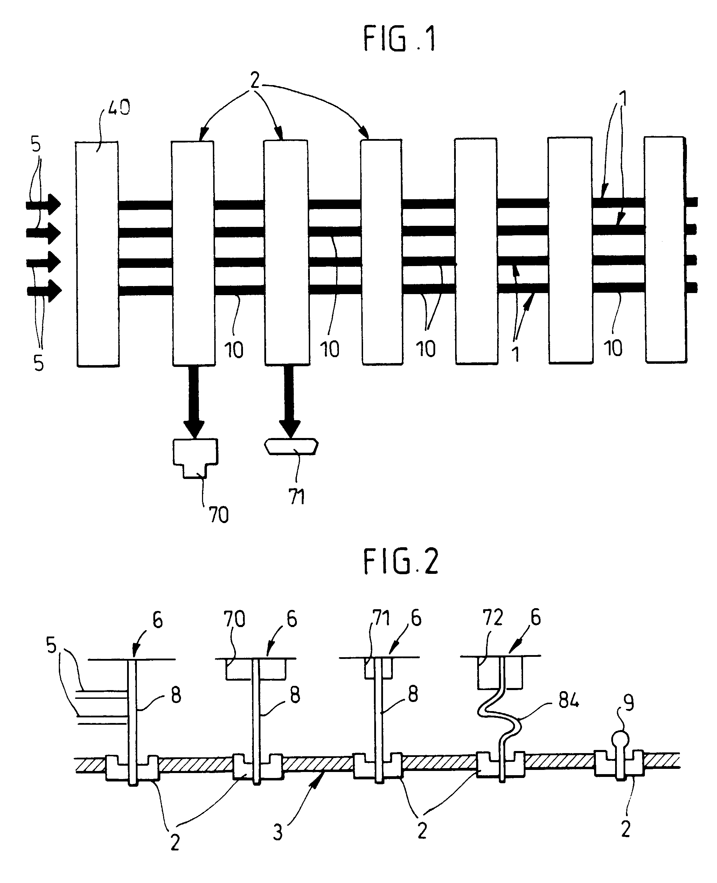

Comme on l'a schématisé sur la figure 1, le dispositif de connexion selon l'invention comporte au moins un bus 1, quatre sur l'exemple représenté. Ces bus 1 sont portés par un support isolant 3, non représenté sur la figure 1, pouvant de manière connue en soi être rigide ou souple.

Chaque bus 1 est formé sur le support isolant 3 sous forme de segments 10 séparés les uns des autres, le dispositif de connexion selon l'invention comportant des moyens de jonction 2 destinés à être interposés dans chaque séparation entre deux segments 10 de bus 1.

Les moyens de jonction 2 sont tels qu'ils assurent la transmission des signaux de l'un à l'autre des segments 10 formant les bus 1.

Dans les formes de réalisation représentées aux figures 2 à 6, lesdits moyens de jonction 2 sont fixés sur le support isolant 3.

Sur les figures 2 à 4, lesdits moyens de jonction 2 sont des boîtiers comportant autant de contacts que nécessaire montés dans des ouvertures du support isolant 3 situées à chaque séparation des segments de bus.

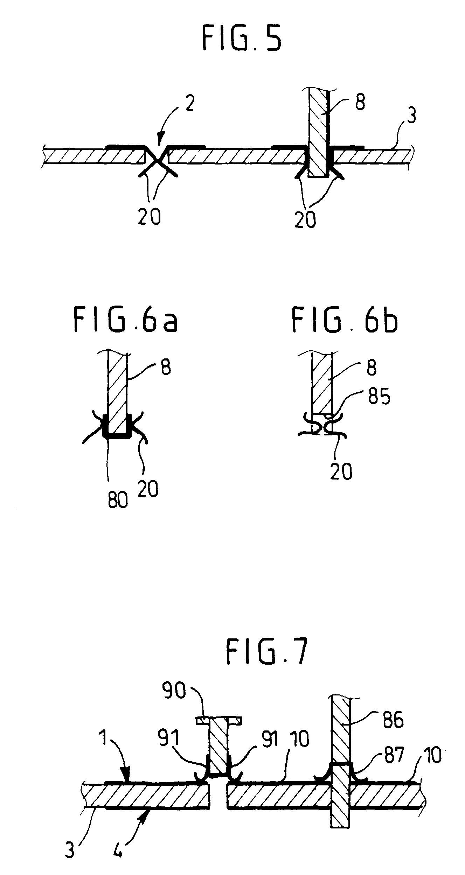

En variante, comme représenté à la figure 5, lesdits moyens de jonction 2 sont formés par une juxtaposition de contacts 20 fixés sur le support isolant 3 de manière à être en liaison électrique avec un segment de bus. Cette réalisation permet d'éviter la fabrication de boîtiers spécialement adaptés en dimension et nombre de contacts aux dispositifs de connexion envisagés.

De manière préférée, les contacts de ces moyens de jonction sont des contacts fermés en position de repos afin d'assurer à eux seuls la continuité de chaque fil de chacun des bus.

L'on peut également utiliser des moyens à contacts ouverts au repos dans lesquels sont positionnés des pions de liaison 9 des contacts.

Sur un côté du support, à gauche sur la représentation de la figure 1, un bornier 40 assure la jonction des câbles 5 de transmission de signaux et des bus 1 du dispositif de connexion selon l'invention.

Ce bornier 40 peut être prévu sous une forme connue usuellement utilisée pour la connexion entre des câbles et des pistes de circuit imprimé.

Comme représenté, chaque câble 5 est disposé en liaison avec l'un des bus 1 afin que les signaux véhiculés par ledit câble soient transmis à ce bus. En variante et de manière connue en soi, il est bien entendu possible d'alimenter un bus avec plusieurs câbles ou à l'inverse d'alimenter plusieurs bus avec un câble comportant assez de fils.

Comme schématisé à la figure 2, des plots 6 portant des connecteurs spécifiques 70, 71, 72 peuvent être insérés dans les moyens de jonction 2, ils font ainsi partie des moyens de jonction entre les segments de bus.

Lorsque les moyens de jonction sont à contacts normalement ouverts, lesdits plots sont positionnés à la place des pions de liaison 9 de contacts, l'on pourrait également prévoir un positionnement mécanique du plot sur le pion.

Ces plots assurent la transmission des signaux véhiculés par l'un des bus 1 au connecteur spécifique qu'il porte.

Dans l'exemple représenté à la figure 2, le bornier utilisé est de même forme que les plots 6, les câbles 5 sont connectés à ce plot et ledit plot 6 assure la transmission des signaux aux bus 1 par l'intermédiaire du moyen de jonction 2 dans lequel il est inséré.

Le circuit imprimé mis en oeuvre dans la présente invention est un circuit à impédance caractéristique choisie de valeur égale ou très proche à celle des câbles d'alimentation, soit de l'ordre de 100 à 120 Ohms pour les circuits de transmission de signaux de télématique.

L'utilisation d'un tel circuit à impédance caractéristique définie contrôlée permet d'assurer une bonne conservation des caractéristiques des signaux véhiculés quelle que soit la longueur du circuit imprimé ; mis à part un léger affaiblissement dont il est impossible de s'affranchir.

Pour obtenir un circuit à impédance caractéristique contrôlée, l'on dispose des conducteurs de masse au voisinage des pistes véhiculant les informations.

La valeur de l'impédance caractéristique d'un circuit imprimé est alors une fonction des caractéristiques dimensionnelles des pistes formant le bus, des conducteurs de masse et du diélectrique les séparant formé par le support isolant.

Les figures montrent une forme de réalisation d'un tel circuit imprimé à impédance caractéristique.

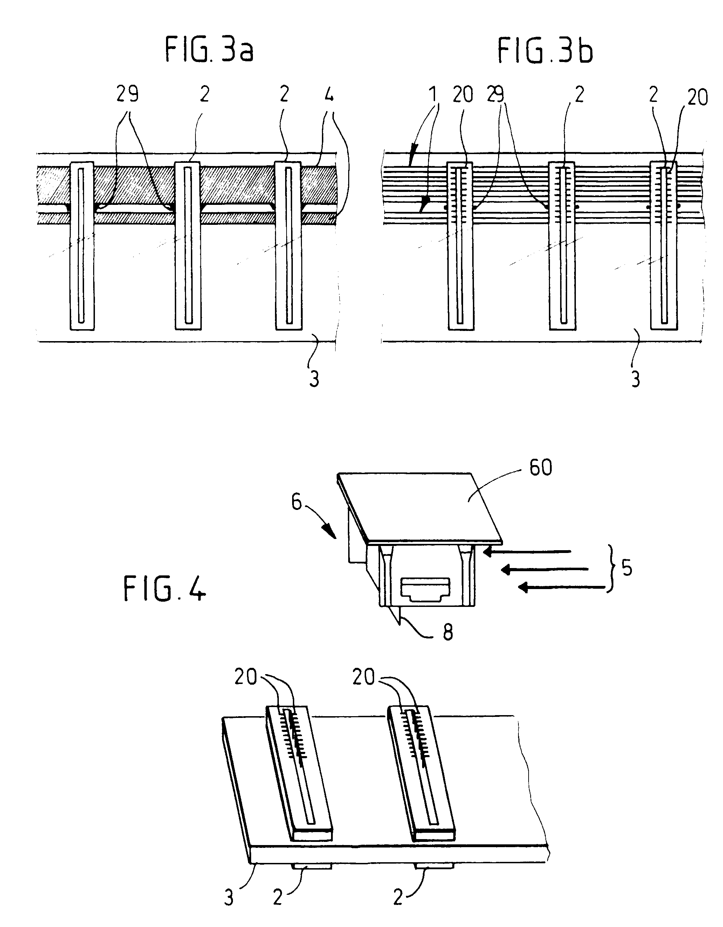

La figure 3b montre en partie le verso de la carte de circuit imprimé prévue pour la mise en oeuvre de l'invention.

Le bus 1 représenté est un bus à 8 fils, les 8 contacts supérieurs des moyens de jonction 2 sont donc utilisés pour la transmission des 8 signaux du bus L supérieur. Comme on peut le voir, un neuvième contact 29 des moyens de jonction 2 n'est relié à aucun fil sur la face représentée à la figure 3b.

Ce neuvième contact 29 est relié à un plan de masse 4 prévu au recto du support isolant 3. Le plan de masse 4 est, comme représenté, disposé en segments correspondants à ceux du bus et reliés eux aussi par les moyens de jonction 2. Il est bien entendu prévu autant de plans de masse que de bus.

Chaque plan de masse est relié au blindage du câble amenant les informations au bus qui lui correspond.

Les plans de masse sont de manière préférée sur la face supérieure du circuit imprimé afin de parfaire le blindage du dispositif de connexion.

Les dimensions des pistes conductrices destinées à former les bus et des plans de masse, et du support isolant sont définies en fonction de l'impédance caractéristique que l'on veut obtenir dans le circuit imprimé. La valeur de l'impédance caractéristique d'un circuit imprimé ainsi formé est alors connue et sa valeur est constante d'un bout à l'autre dudit circuit.

De manière connue en soi, de nombreuses autres dispositions peuvent être adoptées pour former un circuit imprimé à impédance caractéristique définie.

A titre d'exemples nous pouvons citer la formation des conducteurs de masse sous forme de pistes disposées de part et d'autre de chacune des pistes du bus, ou encore la disposition des pistes du bus à l'intérieur d'un support isolant présentant sur chacune de ses faces un plan de masse.

La figure 4 présente un exemple de mise en oeuvre de l'invention. Le support isolant 3 portant le circuit imprimé de l'invention est dimensionné afin d'être positionné dans tous boîtiers appropriés et de manière préférée dans des rails extrudés, non représentés, tels que ceux souvent utilisés dans les installations de bureaux.

Lorsque le dispositif de connexion est positionné dans un boîtier ou un rail, le plot 6 est conformé de manière telle que sa face supérieure 60 s'adapte, par exemple par encliquetage, sur la face ouverte dudit boîtier ou rail.

Le plot 6 porte une cartelette 8 de circuit imprimé destinée à s'insérer dans un moyen de jonction 2.

L'on prévoit deux sortes de plots 6, ceux semblables à celui représenté à la figure 4 qui assurent la jonction des câbles 5 amenant les signaux aux bus par l'intermédiaire du moyen de jonction 2, et ceux présentant sur leur face supérieure 60 un connecteur spécifique auquel sont amenés les signaux véhiculés par l'un des bus. L'on prévoira ainsi des cartelettes capables de prélever les signaux sur le bus supérieur, ou sur le second, ou sur le troisième, etc selon le nombre de bus du circuit imprimé.

La cartelette 8 peut également porter un circuit imprimé assurant une fonction, par exemple protection contre les surtensions, filtrage ou encore réalisation de tests destinés au contrôle de l'état de l'installation.

La cartelette 8 est formée soit par un support rigide de type classique, soit par un film imprimé souple comme représenté en 84. Le film imprimé souple présente l'avantage de pouvoir être prévu plus long que le support rigide du fait qu'il peut former des plis lorsque l'on fixe la face supérieure 60 du plot à sa place définitive. Ce film souple 84 est muni à son extrémité inférieure d'un élément rigide permettant l'insertion dans le moyen de jonction. Son utilisation à la place d'un support rigide permet, en le rabattant sur le côté, de mieux surveiller la connexion dans le moyen de jonction lors du montage du plot.

Comme représenté schématiquement à la figure 6a, la cartelette 8 porte des pistes 80 qui entrent en contact avec les contacts 20 du moyen de jonction 2.

Les pistes disposées en regard des contacts 20 reliés aux fils du bus transportant les signaux à utiliser assurent la transmission desdits signaux vers l'utilisation, connecteur spécifique ou fonction. La cartelette assure de plus la jonction des contacts du moyen de jonction 2 reliés aux lignes des bus non utilisés afin que son insertion dans un moyen de jonction ne perturbe pas les bus non utilisés.

Comme représenté à la figure 6b, et dans le cas où les moyens de jonction mis en oeuvre sont à contacts normalement fermés, la cartelette peut présenter une ou des encoches 85 lui permettant de ne pas ouvrir les contacts correspondants aux bus non utilisés. L'utilisation d'une cartelette sans encoche est toutefois préférée car elle permet un meilleur guidage et un meilleur positionnement mécanique de celle-ci.

En ce qui concerne le bus dont les données sont utilisées dans un plot 6, il peut être prévu plusieurs formes de prise en charge des signaux par la cartelette 8.

En premier lieu, le circuit imprimé porté par la cartelette peut être tel qu'il prenne les informations véhiculées par le bus sur une de ses faces afin de les utiliser tout en assurant la continuité de leur propagation vers l'aval du bus. Un tel circuit sera obligatoirement utilisé pour les cartelettes portant des fonctions telles qu'une protection contre les surtensions ou un filtrage, afin que toute la ligne en aval soit protégée, il peut également être utilisé pour les plots portant un connecteur spécifique.

L'utilisation d'une cartelette n'interrompant pas le passage des informations vers l'aval dans un plot portant un connecteur spécifique est nécessaire lorsqu'il est possible de brancher plusieurs appareils en parallèle sur le même bus distributeur d'information ou lorsque l'on désire disposer de place en aval pour l'insertion de tests.

Lorsqu'il n'est pas souhaitable de brancher d'autre appareil, l'on peut également ne pas perturber la propagation des signaux, l'on préfèrera toutefois dans ce cas utiliser une cartelette traitant les signaux mais ne les restituant pas en aval afin de réduire la charge sur la ligne.

L'installation d'une cartelette coupant la propagation des signaux sur le bus dont l'on utilise les signaux permet de manière avantageuse une seconde utilisation du bus. En effet, le bus étant interrompu au point d'utilisation, il est possible de brancher un nouveau bornier en aval de ce point, par exemple à l'autre extrémité du support isolant afin d'amener sur la seconde partie de bus séparée de la première d'autres signaux utilisables par d'autres plots positionnés en aval de la coupure.

Les plots peuvent encore être prévus avec deux cartelettes destinées à s'insérer dans deux moyens de jonction 2 éloignés l'un de l'autre dans le cas où la fonction qu'ils assurent nécessite une installation assez volumineuse. La cartelette située en amont capte alors les signaux arrivant du bus sur les contacts amonts du moyen de jonction 2 tandis que la cartelette située en aval restitue les signaux au bus par les contacts avals du moyen de jonction. En cas de besoin, pour des utilisations particulières, il est également possible de restituer les signaux sur un autre bus que celui sur lequel ils ont été prélevés, à condition bien entendu de ne pas interférer avec d'autres signaux présents sur ce second bus.

La figure 7 montre une troisième forme de réalisation du dispositif de connexion selon l'invention dans laquelle le support isolant 3 ne porte que les pistes formant les segments 10 de bus 1 et les segments de plans de masse 4. Les moyens de jonction sont formés par des pions 90 portant des contacts 91 assurant la jonction des pistes de même nature. L'on a également représenté à la figure 7 un exemple de réalisation de cartelette 86 portant des contacts 87 destinés à traiter les signaux véhiculés par les bus 1. Dans ce cas également, la cartelette est insérée dans le moyen de jonction même si cette insertion n'est pas un montage physique de la cartelette dans un moyen.

Le nombre de bus portés par le support isolant, le nombre de fils les composant et le nombre de moyens de jonction portés par le support isolant sont choisis en fonction des caractéristiques des signaux transportés et de la place disponible sur le support.

Il est également possible d'utiliser une carte comportant des bus présentant moins de fils que nécessité et de créer par exemple un bus à huit fils avec deux bus à quatre fils en court-circuitant les deux plan de masses pour qu'ils ne fassent qu'un.

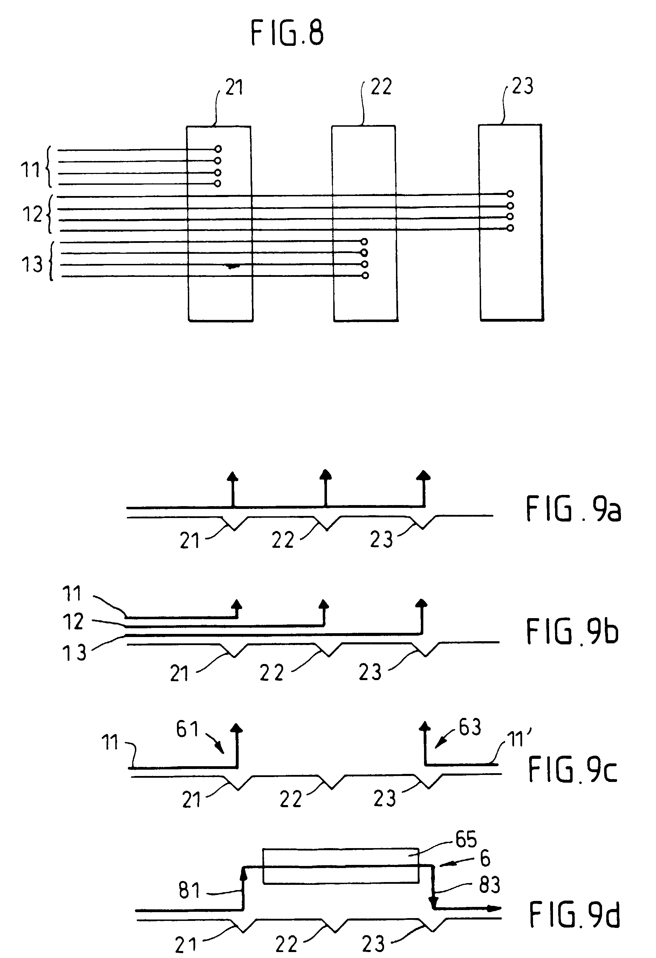

La figure 8 représente schématiquement un circuit imprimé portant trois bus 11, 12, 13 à quatre fils et trois moyens de jonction 21, 22, 23. Dans l'exemple représenté, le plot inséré dans le moyen de jonction amont 21, à gauche de la figure, utilise les signaux véhiculés par le bus supérieur 11 et ne les restitue pas en aval, tandis qu'il assure la transmission des signaux des deux autres bus 12 et 13. Le plot inséré dans le second moyen de jonction 22 utilise les signaux du bus inférieur 13 sans les restituer en aval tout en assurant la continuité du bus médian 12. Enfin, le plot inséré dans le troisième moyen de jonction 23 utilise les signaux du bus médian 12.

Les figures 9a à 9d représentent différentes utilisations possibles d'un circuit imprimé à trois bus et trois moyens de jonction.

A la figure 9a, les trois plots insérés dans les moyens de jonction 21, 22, 23 utilisent les signaux du même bus 11, les appareils déservis étant en parallèle.

A la figure 9b, chaque plot utilise les signaux d'un bus différent et ne les restitue pas.

A la figure 9c, le plot 61 inséré dans le moyen amont 21 utilise les signaux du bus 11 et coupe la communication vers l'aval et le plot 63 inséré dans le moyen aval 23 utilise sur le même bus des signaux différents injectés en aval, on a ainsi créé un bus 11' supplémentaire. Un autre plot pourrait être disposé sur le moyen de jonction central 22 pour utiliser les signaux d'un autre bus.

A la figure 9d, le plot 6 est de grande dimension et porte deux cartelettes, la cartelette amont 81 captant les signaux sur les contacts amonts du moyen de jonction 21 sans les restituer sur les contacts avals dudit moyen de jonction 21, tandis que la cartelette aval 83 restitue sur les contacts avals du moyen de jonction aval 23 des signaux après leur traitement par le circuit 65 porté par le plot, lesdits signaux restitués pouvant être ou non identiques aux signaux arrivant en amont du plot 6.

Sur le plan pratique, les séparations entre segments de bus et de plan de masse et donc les moyens de jonction seront répartis de manière telle que l'on puisse utiliser pour les plots, des faces avant de dimensions courantes.

Ces séparations peuvent être disposées à un pas plus petit et ne pas être toutes utilisées pour la mise en place de plots. Il est également possible de ne pas les répartir de manière régulière.

Comme l'on aura pu le comprendre, le dispositif de connexion suivant l'invention permet de disposer d'installations pouvant évoluer de manière très aisée suivant les besoins des utilisateurs dès lors, qu'au moment de l'installation, l'on prévoit des circuits imprimés présentant plus de séparations que nécessaire dans l'immédiat.

Avec le dispositif suivant l'invention, il est possible de modifier la place des connecteurs spécifiques en fonction de l'aménagement en changeant simplement la place des plots les portant, il est également possible d'ajouter autant de connecteurs spécifiques que nécessaire en positionnant les plots les portant dans les dispositifs de jonction. Il est encore possible de changer les connecteurs spécifiques en remplaçant simplement les plots si les informations à utiliser restent les mêmes.

Ainsi, en alimentant par exemple l'un des bus avec les signaux nécessaires aux installations téléphoniques, un autre, ou d'autres, bus avec les signaux nécessaires à des ordinateurs, l'on dispose d'une installation permettant de brancher en tout emplacement désiré le matériel nécessaire et de modifier ce branchement sans nécessiter d'interventions coûteuses.

Toutes ces modifications sont possibles par le fait que les cartelettes portées par les plots assurent la prise des informations nécessaires sur un bus sans perturber le fonctionnement des autres bus et par le fait que les informations véhiculées ne subissent pas de dégradations quelle que soit la longueur du circuit imprimé par le respect d'une valeur définie de l'impédance caractéristique.

Le dispositif selon l'invention permet également d'insérer très facilement des dispositifs de protection ou de filtrage si cela s'avère nécessaire en utilisation.

Le dispositif selon l'invention permet encore de manière avantageuse d'effectuer des contrôles de manière rapide en insérant un plot adéquat dans un moyen de jonction quelconque du circuit imprimé, à la seule condition que les signaux soient présents sur le bus que l'on désire examiner (c'est-à-dire en amont de l'utilisateur si la cartelette du plot de branchement interrompt la transmission vers l'aval). Tous les contrôles peuvent être faits sans nécessiter de modification de branchement.

A l'heure actuelle, les circuits de test doivent être montés dans les circuits d'alimentation et ne peuvent en être démontés, ce qui oblige à disposer d'autant de circuits de test que de postes d'utilisation à contrôler.

Grâce au dispositif selon l'invention, le contrôleur insère un plot dans un moyen de jonction, réalise ses essais puis reprend le plot de contrôle. Le nombre de dispositifs de contrôle est ainsi largement diminué puisque chacun est récupéré et réutilisé à tout moment.

De manière avantageuse, le dispositif de connexion selon l'invention permet également dans de nombreux cas une modification très rapide et peu coûteuse de l'installation lors d'un changement de matériel.

Dans le cas où les signaux nécessaires restent les mêmes, il suffit de changer les plots pour disposer soit de nouveaux connecteurs spécifiques, soit d'un nouveau circuit de traitement dans la cartelette.

Si les signaux doivent être modifiés, l'on pourra selon les cas modifier le câblage en amont du câble fournissant les informations au bus, ou au niveau du bornier ou encore au niveau de la cartelette. Le câble n'a pas à être forcément changé à chaque modification tant qu'il comporte au moins le nombre de fils nécessaire à la nouvelle utilisation.

Afin d'éviter la fabrication d'autant de cartelettes pour les plots 6 qu'il y a de combinaisons possibles de connecteurs spécifiques et d'emplacement du bus dont sont prises les informations, il est possible de prévoir des cartelettes dites programmables.

Par exemple, prenons le cas d'une installation présentant trois bus à huit fils. Chaque connecteur pourra donc être relié à l'un au choix de ces trois bus.

L'on prévoit alors une cartelette assurant en parallèle la liaison du connecteur à chacun des trois bus. Au moment de l'installation, l'utilisateur pourra alors prendre cette cartelette et détruire les jonctions inutiles au lieu de rechercher parmi des cartes présentant chacune l'un des trois branchements possibles la carte adéquate.

Cette programmation pourra se faire par tout moyen de destruction ponctuelle des pistes mécanique ou électrique, tel qu'un arc électrique.

L'on a ainsi une standardisation des cartelettes permettant de toujours avoir à sa disposition une carte utilisable dans la configuration nécessaire.

Bien entendu le support isolant portant le circuit imprimé peut être un support rigide de type usuel ou un film souple.

## Revendications

1. Dispositif de connexion pour le captage de signaux provenant d'un réseau combiné, comportant:
- un circuit imprimé portant au moins un bus (1, 11, 12, 13) placé sur un support isolant, pour être alimenté en service par un réseau au moyen d'un câble d'alimentation (5), et des conducteurs de masse (4), de telle sorte que ledit circuit imprimé soit à impédance caractéristique d'une valeur constante sur toute la longueur du bus (1, 11, 12, 13), laquelle valeur étant apte à correspondre à celle des câbles d'alimentation qui, en service, assurent le branchement du dispositif à un réseau, ledit bus (1, 11, 12, 13) étant disposé en segments (10) consécutifs séparés par des moyens de jonction (2) permettant le captage à choix de signaux en provenance du réseau bien qu'assurant la transmission des autres signaux d'un segment au suivant, et
- des moyens de connexion ou plots (6) comportant une cartelette (8) de circuit imprimé destinée à l'utilisation des informations transportées par au moins un bus positionnés dans les moyens de jonction (2), chaque cartelette (8) présentant des moyens disposés en regard du bus transportant les signaux à utiliser assurant la transmission de signaux de certains bus uniquement vers l'utilisation et d'autres moyens assurant la jonction de tous les segments des bus transportant des signaux non utilisés par moyen de cette cartelette.

2. Dispositif selon la revendication 1, caractérisé en ce que les moyens de jonction (2, 21, 22, 23) comportent des contacts fermés en position de repos afin d'assurer la continuité de chacun des bus (1, 11, 12, 13) et conducteurs de masse (4).

3. Dispositif selon la revendication 1, caractérisé en ce que les moyens de jonction (2, 21, 22, 23) comportent des contacts ouverts au repos dans lesquels sont insérés des pions de liaison (9) des contacts afin d'assurer la continuité de chacun des bus (1, 11, 12, 13) et conducteurs de masse (4).

4. Dispositif selon la revendication 1, caractérisé en ce que les moyens de jonction sont des pions (90) portant des contacts (91) assurant la jonction des segments de bus (1) et des conducteurs de masse (4).

5. Dispositif selon l'une quelconque des revendications précédentes, caractérisé en ce qu'un bornier (40) assure la jonction du ou des câbles (5) de transmission de signaux au ou aux bus (1).

6. Dispositif selon la revendication 5, caractérisé en ce que le bornier (40) est un bornier conforme à ceux usuellement utilisés pour assurer la connexion entre des câbles et des pistes de circuit imprimé.

7. Dispositif selon l'une quelconque des revendications précédentes, caractérisé en ce que la cartelette (8) de circuit imprimé des plots (6) présente des pistes (80) entrant en contact, directement ou indirectement, avec les segments de bus (1) et de conducteurs de masse (4).

8. Dispositif selon les revendications 5, caractérisé en ce qu'un plot (6) assure la jonction des câbles (5) et des bus (1) par l'intermédiaire d'un moyen de jonction (2).

9. Dispositif selon l'une quelconque des revendications précédentes, caractérisé en ce que les plots (6) présentent une face supérieure (60) portant un connecteur spécifique auquel sont amenés les signaux véhiculés par l'un des bus.

10. Dispositif selon l'une quelconque des revendications précédentes, caractérisé en ce que la cartelette (8) porte un circuit imprimé assurant une fonction.

11. Dispositif selon l'une quelconque des revendications précédentes, caractérisé en ce que le support isolant est inséré dans un rail.

12. Dispositif selon l'une quelconque des revendications 7 à 11, caractérisé en ce que les cartelettes (8) sont programmables par tout moyen mécanique ou électrique.

## Patentansprüche

1. Verbindervorrichtung für die Abnahme von Signalen, die von einem Schaltnetz stammen, wobei die Vorrichtung folgende Merkmale umfaßt:
- eine gedruckte Schaltung, die zumindest einen auf einem isolierenden Träger angebrachten Bus (1, 11, 12, 13) trägt, um im Betrieb von einem Netz mittels eines Versorgungskabels (5) und Masseleitungen (4) versorgt zu werden, und zwar derart, daß die gedruckte Schaltung eine charakteristische Impedanz mit einem konstanten Wert über die ganze Länge des Busses (1, 11, 12, 13) aufweist, wobei dieser Wert geeignet ist, mit demjenigen der Versorgungskabel übereinzustimmen, die im Betrieb den Anschluß der Vorrichtung an ein Netz sicherstellen, wobei der Bus (1, 11, 12, 13) in aufeinanderfolgende, durch Verbindungsmittel (2) getrennte Segmente (10) aufgeteilt ist, was die wahlweise Abnahme von Signalen, die von Netz herkommen, erlaubt, wie auch die Übertragung der anderen Signale von einem Segment zum nächsten sicherstellt, und
- Verbindungsmittel oder Verbindungsklemmen (6), die eine kleine gedruckte Platine (8) umfassen, die zur Verarbeitung der Informationen bestimmt ist, die durch zumindest einen in den Verbindungsmitteln (2) liegenden Bus befördert werden, wobei jede Platine (8) Mittel aufweist, die gegenüber dem Bus, der die zu verwendenden Signale übermittelt, angebracht sind und die Signalübertragung gewisser Busse einzig zur Weiterverwendung sicherstellen, und andere Mittel, welche die Verbindung aller Bussegmente, die nicht verwendete Signale mittels dieser Platine befördern, sicherstellen.

2. Vorrichtung nach Anspruch 1, dadurch gekennzeichnet, daß die Verbindungsmittel (2, 21, 22, 23) in Ruhestellung geschlossene Kontakte tragen, um den Zusammenhang sowohl des Busses (1, 11, 12, 13) als auch der Masseleiter (4) sicherzustellen.

3. Vorrichtung nach Anspruch 1, dadurch gekennzeichnet, daß die Verbindungsmittel (2, 21, 22, 23) in Ruhestellung offene Kontakte tragen, in die Kontaktverbindungsbolzen (9) eingesetzt sind, um den Zusammenhang sowohl des Busses (1, 11, 12, 13) als auch der Masseleiter (4) sicherzustellen.

4. Vorrichtung nach Anspruch 1, dadurch gekennzeichnet, daß die Verbindungsmittel Bolzen (90) sind, die Kontakte (91) tragen, welche die Verbindung der Bussegmente (1) und der Masseleiter (4) sicherstellen.

5. Vorrichtung nach einem der vorangegangenen Ansprüche, dadurch gekennzeichnet, daß eine Klemme (40) die Verbindung des oder der Signalübertragungskabel (5) mit dem oder den Bus(sen) (1) sicherstellt.

6. Vorrichtung nach Anspruch 5, dadurch gekennzeichnet, daß die Klemme (40) eine Klemme ist, die mit den gebräuchlich verwendeten übereinstimmt, um den Anschluß zwischen den Kabeln und den gedruckten Leiterbahnen sicherzustellen.

7. Vorrichtung nach einem der vorangegangenen Ansprüche, dadurch gekennzeichnet, daß die gedruckte Platine (8) der Klemmen (6) Bahnen (80) aufweist, die direkt oder indirekt mit den Bussegmenten (1) und Masseleitern (4) in Kontakt treten.

8. Vorrichtung nach Anspruch 5, dadurch gekennzeichnet, daß eine Klemme (6) die Verbindung der Kabel (5) und des Busses (1) über ein Verbindungsmittel (2) sicherstellt.

9. Vorrichtung nach einem der vorangegangenen Ansprüche, dadurch gekennzeichnet, daß die Klemmen (6) eine obere Fläche (60) aufweisen, die ein besonderes Verbindungsstück trägt, dem die Signale, die durch einen der Busse befördert werden, zugeleitet werden.

10. Vorrichtung nach einem der vorangegangenen Ansprüche, dadurch gekennzeichnet, daß die Platine (8) eine gedruckte Schaltung trägt, die eine Funktion sicherstellt.

11. Vorrichtung nach einem der vorangegangenen Ansprüche, dadurch gekennzeichnet, daß der isolierende Träger in eine Schiene eingesetzt ist.

12. Vorrichtung nach einem der Ansprüche 7 bis 11, dadurch gekennzeichnet, daß die Platinen (8) durch jedes mechanische oder elektrische Mittel programmierbar sind.

## Claims

1. A connecting device for picking up signals coming from a combined network, comprising:
- a printed circuit bearing at least one bus (1, 11, 12, 13) placed on an isolating support, to be fed during operation by a network by means of a feed cable (5), and earth leads (4), such that said printed circuit has a characteristic impedance of a value which is constant over the entire length of the bus (1, 11, 12, 13), said value being suitable for corresponding with that of the feed cables which, in operation, connect the device to a network, said bus (1, 11, 12, 13) being arranged in consecutive segments (10) separated by junction means (2) permitting the selective picking-up of signals coming from the network although ensuring transmission of the other signals from one segment to the next, and
- connection means or contact blocks (6) comprising a printed circuit card (8) intended for using the information carried by at least one bus and positioned in the junction means (2), each card (8) having means arranged opposite the bus transporting the signals to be used ensuring the transmission of signals from certain buses solely for use and other means ensuring the junction of all the segments of the buses transporting non-used signals by means of this card.

2. A device according to Claim 1, characterised in that the junction means (2, 21, 22, 23) comprise contacts which are closed in the initial position in order to ensure the continuity of each of the buses (1, 11, 12, 13) and earth leads (4).

3. A device according to Claim 1, characterised in that the junction means (2, 21, 22, 23) comprise contacts which are open at rest into which are inserted connecting pins (9) of the contacts in order to ensure the continuity of each of the buses (1, 11, 12, 13) and earth leads (4).

4. A device according to Claim 1, characterised in that the junction means are pins (90) bearing contacts (91) ensuring the junction of the segments of the bus (1) and the earth leads (4).

5. A device according to any one of the preceding claims, characterised in that a terminal block (40) ensures the junction of the cable or cables (5) for transmitting signals to the bus or buses (1).

6. A device according to Claim 5, characterised in that the terminal block (40) is a terminal block in accordance with those usually used for providing the connection between cables and printed circuit tracks.

7. A device according to any one of the preceding claims, characterised in that the printed circuit card (8) of the contact blocks (6) has tracks (80) which come into contact, directly or indirectly, with the segments of the bus (1) and earth leads (4).

8. A device according to Claim 5, characterised in that a contact block (6) ensures the junction of the cables (5) and the buses (1) by means of a junction means (2).

9. A device according to any one of the preceding claims, characterised in that the contact blocks (6) have an upper face (60) bearing a specific connector to which the signals carried by one of the buses are brought.

10. A device according to any one of the preceding claims, characterised in that the card (8) bears a printed circuit which performs a function.

11. A device according to any one of the preceding claims, characterised in that the isolating support is inserted in a rail.

12. A. device according to any one of Claims 7 to 11, characterised in that the cards are programmable by any mechanical or electrical means.
